(19) Europäisches Patentamt / European Patent Office / Office européen des brevets

(11) **EP 2 797 157 B1**

(12) **FASCICULE DE BREVET EUROPEEN**

(45) Date de publication et mention
de la délivrance du brevet:
**28.10.2015 Bulletin 2015/44**

(51) Int Cl.:
*H01M 10/48* (2006.01)  *G01R 31/36* (2006.01)
*H02J 7/00* (2006.01)  *H01M 10/42* (2006.01)

(21) Numéro de dépôt: **14165333.7**

(22) Date de dépôt: **18.04.2014**

(54) **Système de batterie de puissance pour la determination de l'impedance d'un etage**

Leistungsstarkes Batteriesystem zur Bestimmung der Impedanz eines Moduls

Power battery system for determining the impedance of a module

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.04.2013 FR 1353656**

(43) Date de publication de la demande:
**29.10.2014 Bulletin 2014/44**

(73) Titulaire: **Commissariat à l'Énergie Atomique et aux Énergies Alternatives
75015 Paris (FR)**

(72) Inventeurs:
  • **Cattin, Viviane
    38120 SAINT EGREVE (FR)**
  • **Al Nazer, Rouba
    38000 GRENOBLE (FR)**
  • **Montaru, Maxime
    15170 JOURSAC (FR)**

(74) Mandataire: **GIE Innovation Competence Group
310 bis, Avenue Berthelot
69008 Lyon (FR)**

(56) Documents cités:
**JP-A- 2011 130 550    US-A1- 2012 306 504**

• **FAIRWEATHER A J ET AL: "Battery parameter identification with Pseudo Random Binary Sequence excitation (PRBS)", JOURNAL OF POWER SOURCES, ELSEVIER SA, CH, vol. 196, no. 22, 22 juin 2011 (2011-06-22), pages 9398-9406, XP028283666, ISSN: 0378-7753, DOI: 10.1016/J.JPOWSOUR.2011.06.072 [extrait le 2011-07-08]**

**Description**

L'invention concerne les batteries d'accumulateurs électrochimiques de puissance. Celles-ci peuvent par exemple être utilisées dans le domaine des transports électriques et hybrides ou les systèmes embarqués.

Un accumulateur électrochimique a habituellement une tension nominale de l'ordre de grandeur suivant:

   1.2 V pour des batteries de type NiMH,
   3.3 V pour une technologie Lithium ion phosphate de fer, LiFePO4,
   4.2 V pour une technologie de type Lithium ion à base d'oxyde de cobalt ;
   2 V pour une technologie au Plomb ;

Ces tensions nominales sont trop faibles par rapport aux exigences de la plupart des systèmes à alimenter. Pour obtenir le niveau de tension adéquat, on place en série plusieurs étages. Pour obtenir de fortes puissances et capacités, on place plusieurs accumulateurs en parallèle dans chaque étage. Le nombre d'étages (nombre de groupes d'accumulateurs) et le nombre d'accumulateurs en parallèle dans chaque étage varient en fonction de la tension, du courant et de la capacité souhaités pour la batterie. L'association de plusieurs accumulateurs est appelée une batterie d'accumulateurs.

L'optimisation de l'utilisation de la batterie nécessite une connaissance la plus précise possible des paramètres de fonctionnement de celle-ci.

Parmi les paramètres de fonctionnement qui peuvent s'avérer importants pour la gestion de la batterie, on peut citer l'état de vieillissement de la batterie. L'état de vieillissement est représentatif des pertes de capacité de la batterie suite à l'exécution d'une suite de cycles de charges/décharges. Plusieurs définitions existent pour définir l'état de vieillissement SOH d'une batterie à un instant t.

Une définition connue est la suivante :

$$SOH(t) = C(t) / C(t0)$$

Soit le rapport de la capacité (Ah) de la batterie à l'instant t par rapport à la capacité maximale en sortie d'usine à t0. La dégradation de cette capacité au cours du temps caractérise le vieillissement d'une batterie. La mesure de la capacité C(t) sur une batterie nécessite un cycle de charge / décharge complet, rares dans l'usage courant dans une application à un véhicule automobile. Il est en outre nécessaire d'obtenir une mesure plus fréquente notamment si la batterie subit des microcycles (véhicule hybride par exemple), alors que les microcycles ne permettent pas de parcourir un cycle de charge/décharge complet.

Une autre définition connue est la suivante :

$$SOH(t) = R(t0) / R(t)$$

Soit le rapport de la résistance (ohms) minimale en sortie d'usine à t0 par rapport à la résistance de la batterie à l'instant t. L'augmentation de la résistance au cours du temps caractérise aussi le vieillissement d'une batterie. La détermination de la valeur de SOH devant être assez précise, la mesure de la résistance de la batterie est le plus souvent réalisée dans un laboratoire, notamment afin de disposer d'une température ambiante bien définie. La mesure de résistance peut être réalisée avec des appels de courant à une fréquence généralement supérieure à 1 kHz.

Une autre méthode de détermination du vieillissement implique la définition d'un modèle électrique de la batterie, puis la mise en oeuvre de mesures sur la batterie afin de déterminer les paramètres de la batterie pour ce modèle électrique. La qualité de cette mesure de vieillissement repose fortement sur la précision du modèle électrique choisi au départ. De plus, la bande spectrale de mesure est limitée par la complexité du modèle choisi. En outre, l'algorithme d'identification étant complexe, celui-ci nécessite trop de calcul pour une mise en oeuvre dans des applications embarquées. Pour des applications embarquées, il existe un besoin non satisfait pour la détermination du SOH afin d'adapter les paramètres de fonctionnement d'un moteur électrique par exemple.

Un autre paramètre de fonctionnement fréquemment utilisé dans les processus de gestion des batteries est l'état d'énergie SoE ou l'état de charge SoC de cette batterie. La mesure de l'état de charge est le plus souvent réalisée à base d'un comptage de Coulomb, en fin de cycle de charge. Cependant, cette mesure dérive et nécessite un recalage relativement complexe.

Un autre paramètre de fonctionnement fréquemment utilisé est la puissance disponible en charge et en décharge. Le plus souvent, ces puissances sont déterminées à partir d'abaques en fonction de la température et de l'état de charge de la batterie. Une telle détermination peut s'avérer inappropriée pour des applications embarquées.

Un autre paramètre de fonctionnement fréquemment utilisé est la tension de circuit ouvert (désignée par le terme OCV pour Open Circuit Voltage en langue anglaise). La valeur OCV de charge ou de décharge est un potentiel continu qui varie en fonction de l'état de charge SOC et qui permet donc de recalibrer la valeur de l'état de charge. La détermination de l'OCV repose sur un modèle électrique de la batterie et sur la capacité de ce modèle à représenter le comportement basses fréquences de la batterie. La définition du modèle électrique équivalent de la batterie est basée sur la détermination de l'impédance de la batterie, formant un système non linéaire. Une telle détermination est réalisée sur la base de mesures en laboratoire. Une telle mesure n'est donc ni adaptée à une batterie embarquée, ni adaptée à l'analyse indépendante de différents modules de la batterie.

La gestion d'une batterie selon l'état de la technique comprend en général une observation des grandeurs électriques en sortie, c'est-à-dire aux bornes de la batterie, pour en déduire un diagnostic de son fonctionnement. Cette approche s'avère insuffisante car elle ne permet pas de déterminer avec précision les zones de la batterie, comme les modules ou certains groupes de cellules, qui sont par exemple défaillants ou qui ont des paramètres de fonctionnement propres. Il en résulte dans la pratique une mauvaise optimisation du fonctionnement de la batterie et une baisse très rapide de ses performances dès qu'elle présente une partie défaillante ou moins performante, accompagnée souvent d'une aggravation rapide de son état et d'un vieillissement prématuré.

Pour améliorer cette approche globale, il existe certains procédés de diagnostic qui consistent à observer certains paramètres de fonctionnement au niveau des modules de la batterie. Cette seconde approche permet plus précisément d'observer localement le comportement particulier de certains modules de la batterie. Toutefois, sa mise en oeuvre est complexe et nécessite l'utilisation de nombreux fils électriques, pour relier un dispositif central de diagnostic à chaque module, ce qui peut induire de forts risques électriques car les fils sont susceptibles de chauffer, ou de se dénuder par frottement puis générer des courts-circuits, par exemple entre deux étages relativement éloignés et de différence de potentiel élevée. D'autre part, cette solution nécessite une isolation galvanique intermédiaire pour protéger un calculateur central, dont le potentiel associé à son alimentation peut-être très éloigné des potentiels présents dans la batterie de puissance. Enfin, elle ne permet d'agir que de manière insatisfaisante sur le fonctionnement global de la batterie.

L'invention vise à résoudre un ou plusieurs de ces inconvénients. L'invention vise notamment à proposer une solution réduisant les risques électriques et permettant de gérer individuellement et avec précision des paramètres de fonctionnement d'un étage dans une connexion en série. L'invention porte ainsi sur un système de batterie d'accumulateurs tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :

- la figure 1 est une représentation schématique d'un système de batterie d'accumulateurs dans lequel un premier mode de réalisation de l'invention est mis en oeuvre;
- la figure 2 est un schéma électrique équivalent d'un circuit associé à un étage ;
- la figure 3 est une loi de variation d'une tension de circuit ouvert d'un exemple d'accumulateur en fonction de son état de charge ;
- la figure 4 est un exemple de modèle électrique équivalent pour un accumulateur lithium-ion ;
- la figure 5 est un diagramme de Nyquist schématique représentant une modélisation d'une fonction de transfert d'un accumulateur ;
- la figure 6 est un diagramme de Nyquist tracé pour un exemple d'accumulateur en fonction de son état ce charge ;
- la figure 7 fournit des diagrammes permettant de déduire une durée maximale de variation et une bande spectrale de variation disponibles en fonction d'un courant de polarisation ;
- la figure 8 est une représentation schématique d'un système de batterie d'accumulateurs dans lequel un deuxième mode de réalisation de l'invention est mis en oeuvre ;
- la figure 9 illustre un étage de la batterie illustrée à la figure 8.

L'invention s'applique à une batterie comprenant plusieurs étages connectés en série, chaque étage incluant au moins un accumulateur électrochimique. Un dispositif de contrôle est raccordé aux étages par l'intermédiaire d'une connexion électrique de puissance avec une charge électrique.

Chaque étage comporte un circuit respectif qui lui est accolé. Ce circuit génère une variation de tension aux bornes de l'étage par application d'une séquence binaire à une première fréquence sur un interrupteur de l'étage. Chaque séquence binaire est différente des séquences binaires des autres étages pour discriminer l'étage par rapport aux autres.

Le dispositif de contrôle est programmé pour mesurer la variation de tension en réponse à l'application de la séquence binaire, pour identifier l'étage à l'origine de la variation et pour déterminer l'impédance de l'étage identifié pour la première fréquence à partir de la variation de tension mesurée.

Une telle détermination de l'impédance permet par exemple de connaître précisément des paramètres de fonctionnement des différents étages. Une telle détermination de l'impédance permet également de disposer d'une même séquence binaire pour permettre la mesure de tension à la fréquence adéquate et pour permettre au dispositif de contrôle d'identifier l'étage concerné. Une telle transmission permet de limiter les contraintes d'isolation galvanique du système et permet de réduire son coût en réduisant notamment le câblage de connexion nécessaire à la transmission des informations. Une telle transmission est également robuste face aux risques d'interférences entre les émissions des différents circuits associés aux étages de la batterie.

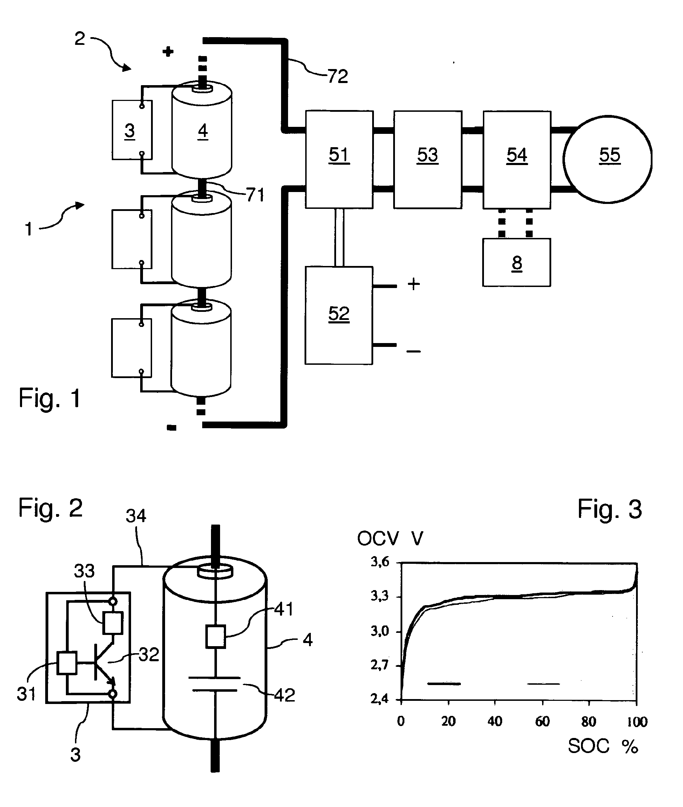

La figure 1 illustre schématiquement un système de batterie d'accumulateurs 1 selon un premier mode de réalisation de l'invention, mis en oeuvre pour assurer l'entraînement d'un moteur électrique 55. Le système 1 comprend une batterie 2 incluant des accumulateurs électrochimiques 4 connectés en série. La batterie 2 comprend un grand nombre d'accumulateurs 4, typiquement entre 20 et 100 accumulateurs en fonction de la tension nécessaire et du type d'accumulateurs utilisé. La tension aux bornes de la batterie est typiquement supérieure à 50 V. Les accumulateurs 4 sont connectés en série par l'intermédiaire de connexions électriques de puissance 71. Chaque accumulateur 4 peut bien entendu être remplacé par un étage d'énergie électrique incluant plusieurs accumulateurs électrochimiques, tel qu'un module incluant des accumulateurs électrochimiques connectés en série et/ou en parallèle dans un conditionnement commun.

La batterie 2 est ici connectée à un module de filtrage 51 par l'intermédiaire de connexions électriques de puissance 72. Un filtre d'antiparasitage électromagnétique 53, dit filtre CEM est également connecté à la batterie 2 par l'intermédiaire des connexions électriques de puissance 72. Le filtre 53 est connecté entre le module de filtrage 51 et un convertisseur alternatif/continu 54. Le convertisseur alternatif/continu 54 est également connecté aux connexions électriques 72 et forme l'interface entre la batterie 2 et les composants fonctionnant en courant alternatif, en l'occurrence un moteur électrique 55 et une source de courant alternatif de recharge 8.

Le filtre 53 permet de façon connue en soi d'éliminer les perturbations électromagnétiques sur le réseau continu lors du fonctionnement du moteur 55. Le filtre 53 permet notamment de filtrer les harmoniques de rang élevé qui peuvent être induites par les circuits de commutation de puissance des forts courants de charge ou de décharge. Un dispositif de contrôle centralisé, formé en l'occurrence d'un calculateur 52 est connecté au module de filtrage 51 pour récupérer un signal basse tension. Du fait de la présence du filtre 53 entre le convertisseur 54 et le module de filtrage 51, toute information transmise depuis un accumulateur n'est pas perturbée par les harmoniques liées au hachage réalisé dans le convertisseur 54 ou dans la commande du moteur 55. Le module de filtrage 51 peut être utilisé pour démoduler des informations fournies depuis les accumulateurs 4.

Dans ce mode de réalisation, chaque accumulateur 4 comporte un circuit 3 qui lui est accolé. Un circuit 3 est par exemple typiquement fixé sur son accumulateur associé, et de préférence alimenté par celui-ci. Chaque circuit 3 a la fonction de générer une variation de tension aux bornes de son accumulateur 4, par application d'une séquence binaire à une première fréquence sur un interrupteur. Pour chaque étage, la séquence binaire est différente de la séquence binaire d'un autre étage, afin de pouvoir discriminer un étage par rapport aux autres étages.

La figure 2 représente un schéma électrique équivalent à un circuit 3 et à son accumulateur associé 4. Le circuit 3 comprend une branche comportant en série un transistor de puissance 32 et une résistance de décharge 33. Cette branche est connectée en parallèle aux bornes de l'accumulateur 4 par l'intermédiaire d'un câble 34. Le circuit 34 comprend également un microcontrôleur 31 connecté aux bornes de l'accumulateur 4.

Le microcontrôleur 31 est configuré pour rendre le transistor 32 passant avec différentes fréquences calibrées et selon des séquences binaires prédéfinies. Le transistor 32 conducteur dérive par exemple un courant d'amplitude calibrée dik pour la tension nominale de son accumulateur 4, durant ses phases de conduction. Durant ses phases de conduction, le transistor 32 induit ainsi une variation de la tension aux bornes de son accumulateur 4. Ce mode de réalisation permet d'assurer un excellent contrôle de la variation de tension et de la fréquence de la séquence binaire. Il n'est alors pas nécessaire de procéder à la mesure de la variation d'amplitude de courant dik, la connaissance de la loi de commande du microcontrôleur 31 et de la valeur de la résistance de décharge 33 étant alors suffisante (par exemple du fait d'une calibration préalable lors de la fabrication du circuit 3, et d'une mémorisation de la valeur dik dans le microcontrôleur 31).

Lorsqu'une variation de tension aux bornes d'un accumulateur 4 est réalisée au moyen d'une séquence binaire à une fréquence donnée, le calculateur 52 réalise :

- une mesure de la variation de la tension aux bornes de cet accumulateur en réponse à l'application de cette séquence binaire sur le transistor 32 associé à cet accumulateur 4;
- une identification de l'accumulateur 4 à l'origine de la variation de tension en recherchant la séquence binaire associée à cet accumulateur ;
- à partir de la variation de tension mesurée, la détermination de l'impédance de l'accumulateur 4 identifié, pour la fréquence de la séquence binaire.

La mesure de la variation de tension d'un accumulateur 4 est avantageusement réalisée lorsque la batterie 2 alimente une charge électrique connectée aux bornes de la connexion électrique de puissance.

Le calculateur 52 peut réaliser l'extrapolation de différents paramètres de fonctionnement de la batterie 2 sur la base d'une mesure d'impédance de ses accumulateurs 4, en connaissant la fréquence pour laquelle cette impédance a été déterminée.

Le calculateur 52 peut procéder au calcul de l'état de charge SOC d'un accumulateur 4. L'état de charge SOC de l'accumulateur sera par exemple calculé sur la base de son impédance suite à une séquence binaire à une fréquence maximale au moins égale à 1 Hz, de préférence au moins égale à 10 Hz, avantageusement inférieure à 50 Hz, et de préférence inférieure à 20 Hz.

Le calculateur 52 peut procéder au calcul de l'état de santé SOH d'un accumulateur. L'état de santé SOH d'un accumulateur sera par exemple calculé sur la base de son impédance suite à une séquence binaire à une fréquence au moins égale à 10Hz, de préférence au moins égale à 100 Hz, et de préférence inférieure à 5 kHz. L'état de santé SOH d'un accumulateur peut par exemple être estimé en déterminant sa résistance (résistance Joule) à partir du modèle détaillé par la suite. On peut par exemple comparer une valeur de résistance en sortie d'usine à une valeur de résistance déterminée pour en déduire l'état de santé SOH.

Le calculateur 52 peut également procéder à l'identification d'un défaut de connectique d'un accumulateur. L'identification d'un défaut de connectique d'un accumulateur pourra par exemple être réalisée sur la base de son impédance suite à une séquence binaire à une fréquence supérieure à 5 kHz. La qualité de la connectique d'un accumulateur peut par exemple être déterminée en déterminant son inductance à partir du modèle détaillé par la suite. On peut par exemple comparer une valeur d'inductance en sortie d'usine à une valeur d'inductance déterminée pour estimer l'état de la connectique.

Le calculateur 52 peut également déterminer la fin d'une décharge de la batterie 2, en déterminant la fréquence de transition de la batterie 2 sur la base de son impédance. Un procédé de calcul de la fréquence de transition basé sur une mesure d'impédance est davantage détaillé dans la demande de brevet WO 2008/046980.

Le calculateur 52 peut procéder au calcul de la puissance de la batterie 2. Ce calcul pourra être réalisé à partir du calcul des puissances des différents accumulateurs 4. La puissance d'un accumulateur 4 pourra être calculée à partir d'une mesure d'état de charge SOC de cet accumulateur 4, combinée à une mesure de la température de la batterie ou de cet accumulateur 4. La puissance d'un accumulateur 4 peut également être déterminée sur la base de la tension OCV.

Le calculateur 52 peut procéder au calcul de la tension OCV (pour Open Circuit Voltage en langue anglaise), cette mesure pouvant être utilisée dans le calcul d'un état de charge SOC déterminé. La figure 3 illustre un exemple de diagramme de tension OCV d'un accumulateur de type Lithium-ion LiFePO$_4$. Le diagramme représente la tension OCV en ordonnée, en fonction de l'état de charge SOC en % en abscisse. La courbe en trait gras correspond à un accumulateur en charge, et la courbe en trait fin correspond à un accumulateur en décharge. Cette courbe présente l'avantage d'être relativement indépendante de la température.

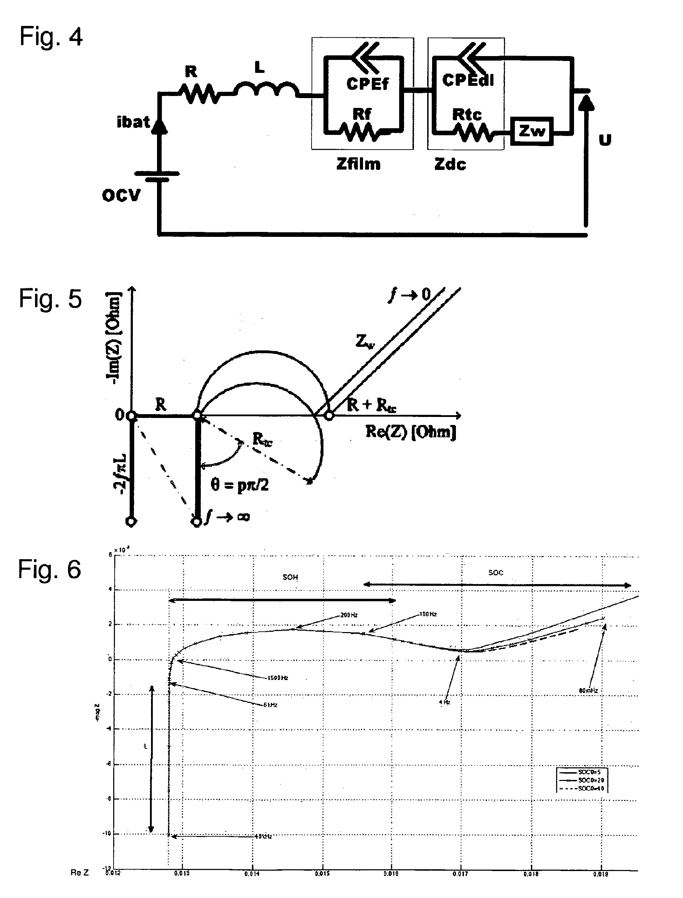

Le calculateur 52 peut également procéder à l'établissement ou à la mise à jour d'un modèle électrique équivalent de la batterie 2. Le modèle illustré à la figure 4 peut par exemple être utilisé. Ce modèle est par exemple décrit dans le document 'Dynamic modeling of Li-ion batteries using an équivalent electrical circuit', rédigé par M. Dong et publié dans Journal of the Electrochemical Society Vol. 158(3), p. A326. Ce modèle vise à prendre en compte les connecteurs, l'électronique, le film de passivation et les transferts de charges. La partie gauche du modèle caractérise le comportement haute fréquence d'une batterie, la partie droite de ce modèle caractérisant son comportement basse fréquence. Ce modèle fait donc apparaître la tension OCV, la résistance R de la batterie, et son inductance L. Les composants CPEf et CPEdl, inclus dans des éléments Zfilm et Zdc respectivement, sont des éléments à phase constante (dits CPE) qui représentent le comportement de la batterie observé suite à des mesures d'impédance par spectroscopie. Un CPE est un composant qui présente un comportement partiellement capacitif et partiellement résistif. Un CPE est défini par les paramètres T et p (avec p compris entre 0 et 1) satisfaisant l'équation suivante pour déterminer son impédance :

$$Zcpe(f) = 1/(T^*(j^*2\pi f)^p)$$

Le modèle d'une batterie peut être établi en mesurant son impédance pour différentes fréquences de séquences binaires. Le circuit 3 peut ainsi être programmé pour appliquer sélectivement la séquence binaire à différentes fréquences.

La figure 5 est un diagramme de Nyquist schématique de l'impédance représentant une fonction de transfert d'un accumulateur selon un tel modèle. La figure 6 est un diagramme de Nyquist tracé suite à des mesures pour un accumulateur pour différents états de charge. En hautes fréquences, au-delà de 6 kHz, la partie inductive de l'accumulateur devient prépondérante, ce qui correspond au front montant de la courbe. La position de ce front montant permet de déterminer la résistance R de l'accumulateur. En moyenne fréquence, entre 4 Hz et 6 kHz, la forme de la courbe est définie principalement par la valeur de la résistance R et de la capacité. En basse fréquence, en dessous de 4 Hz, on constate une forte incidence de l'état de charge de l'accumulateur sur la forme de la courbe.

Le calculateur 52 peut en outre réaliser différentes fonctions, en fonction des paramètres de fonctionnement extrapolés des mesures d'impédance. Par exemple, le calculateur 52 peut estimer la stabilité du système 1, en vérifiant que des mesures successives d'état de charge de la batterie 2 ne présentent pas de différence excessive.

Les paramètres de fonctionnement déterminés par le calculateur 52 sur la base des mesures d'impédance des accumulateurs 4 peuvent être utilisés par le calculateur 52 pour modifier l'utilisation de la batterie 2 : le calculateur 52 peut ainsi modifier l'utilisation de la batterie 2 en fonction de la température, du courant de polarisation ou le d'un mode de charge ou de décharge.

Les séquences binaires peuvent par exemple être appliquées sous forme de chirps, de créneaux ou de séquences binaires pseudo-aléatoire.

Le codage des séquences binaires permettant de discriminer les différents accumulateurs au niveau du calculateur 52 peut ainsi être basé sur un code d'étalement utilisant une séquence binaire pseudo-aléatoire. Une séquence binaire pseudo-aléatoire est une série de bits (0 ou 1) apparemment aléatoire mais qui est en réalité périodique. Une séquence transmise prend le nom de symbole. L'ensemble des symboles possibles respectant les mêmes propriétés prend le nom de code.

Deux caractéristiques de ces séquences sont avantageuses :

1. l'autocorrélation de chaque symbole est élevée. Une haute valeur d'autocorrélation sert à identifier un symbole transmis parmi plusieurs symboles reçus par un démodulateur.
2. l'intercorrélation entre symboles est faible. Une faible valeur d'intercorrélation évite les interférences entre symboles : un démodulateur peut alors fiablement les identifier de façon univoque même s'ils ont été reçus simultanément.

Le code Kasami présente par exemple de très bonnes propriétés d'autocorrélation et d'intercorrélation. Pour vérifier ces propriétés, des tests ont notamment été réalisés avec un code Kasami à 63 bits, qui permet d'avoir 16 symboles différents.

Le microcontrôleur 31 est en outre avantageusement configuré pour mesurer la tension aux bornes de l'accumulateur 4 durant les séquences binaires à une fréquence donnée. Le microcontrôleur 31 est alors en outre configuré pour déterminer l'impédance de l'accumulateur 4 à la fréquence donnée, en fonction de la tension mesurée et de la variation d'amplitude dik.

Ainsi, l'accumulateur 4 est traversé par un courant I lorsque le transistor 32 est non conducteur, et traversé par un courant (I-dik) lorsque le transistor 32 est conducteur.

On désigne par Z l'impédance de la batterie 2 et par U la tension à ses bornes. On désigne par Zk l'impédance de l'accumulateur 4 associé au circuit 3 et par Uk la tension aux bornes de cet accumulateur 4.

En dehors d'une conduction du transistor 32, U=Z*I et Uk=Zk*I. Durant une conduction de courant dik à travers le transistor 32, la tension U est alors définie par U=Z*I - Zk* dik. Durant la conduction, la tension Uk est alors définie par Uk= Zk*I - Zk* dik. L'impédance Zk à la fréquence de la séquence binaire peut donc aisément être déduite d'une mesure de tension Uk par le microcontrôleur 31.

Le microcontrôleur 31 est alors avantageusement apte à communiquer par courant porteur au calculateur 52 la valeur de l'impédance Zk qu'il détermine. Le microcontrôleur 31 communique par courant porteur avec le calculateur 52 par l'intermédiaire des connexions électriques de puissance 71 et 72.

Ainsi, pour une même fréquence de séquence binaire, le calculateur 52 et le microcontrôleur 31 peuvent déterminer la valeur de l'impédance Zk de l'accumulateur 4 à cette fréquence. Pour une fréquence de séquence binaire donnée, le calculateur 52 peut alors comparer la valeur de l'impédance qu'il a lui-même déterminée à la valeur d'impédance déterminée par le microcontrôleur 31. Le calculateur 52 peut donc déterminer un niveau de fiabilité d'une mesure d'impédance réalisée.

Le microcontrôleur 31 transmet avantageusement la valeur d'impédance qu'il a déterminée par courant porteur, au moyen d'une séquence binaire à une fréquence (par exemple 80kHz) différente de celle utilisée pour la mesure de l'impédance. Ainsi, le circuit 3 est utilisé à la fois pour une mesure d'impédance et pour la transmission de cette mesure d'impédance au calculateur 52.

Le déclenchement des séquences binaires pour les mesures d'impédance peut être géré de façon autonome par un circuit 3, ou être commandé par le calculateur 52. La mesure d'impédance par un circuit 3 donné ou par le calculateur 52 peut être déclenchée par différents événements. Par exemple, le calculateur 52 peut détecter la fin de la charge la batterie 2 et commander à un circuit 3 de générer une séquence binaire à une fréquence donnée, afin de calculer par exemple l'état de santé de la batterie. Le calculateur 52 peut également détecter l'arrêt du moteur 55 et décider d'une mesure d'impédance d'un accumulateur 4 à une fréquence donnée, afin de calculer l'état de charge de la batterie 2. La mesure d'impédance à une fréquence donnée peut également être commandée par une temporisation intégrée dans le circuit 3 ou dans le calculateur 52.

Outre la valeur d'impédance déterminée, le microcontrôleur 31 peut en outre être configuré pour transmettre la fréquence pour laquelle cette impédance a été déterminée, en particulier si la mesure de l'impédance n'a pas été commandée par le calculateur 52.

Le microcontrôleur 31 peut également être configuré pour mesurer d'autres paramètres de fonctionnement de l'accumulateur 4, par exemple sa température.

Le courant de polarisation I traversant l'accumulateur 4 doit présenter une vitesse de variation lente par rapport à la fréquence des variations de tension. Ainsi, la contribution du courant de polarisation I à la tension de l'accumulateur 4 peut aisément être filtrée par l'intermédiaire d'un filtre passe-haut. Le courant de polarisation n'induit par exemple pas une variation de plus de 2% de l'état de charge durant la séquence binaire réalisée. Le courant de polarisation I peut être un courant de décharge à travers la charge électrique (ici le moteur 55) ou un courant de charge fourni par la source 8.

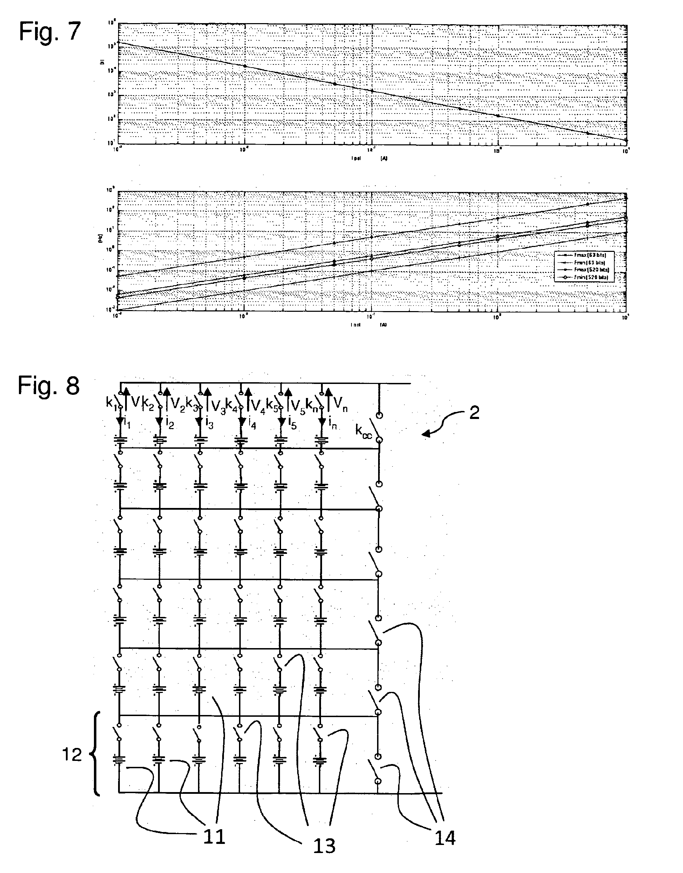

L'amplitude d'une variation de courant dik est à fixer en fonction de l'ordre de grandeur du courant de polarisation I, afin de garantir la stabilité et la linéarité de la batterie 2. Un compromis entre l'amplitude dik, sa durée et le courant de polarisation I est avantageusement respecté afin que la variation d'amplitude dik ne décharge pas la batterie 2 (typiquement dik<1 % I). La durée d'une variation dik dépend du rapport signal sur bruit de la mesure de la tension Uk: une mesure bruitée nécessite un moyennage elevé, donc une répétition d'une séquence binaire. Les diagrammes de la figure 7 permettent d'une part de déterminer la durée maximale possible d'une séquence binaire en fonction du courant de polarisation dans un accumulateur 4, et d'autre part de déterminer la bande spectrale possible pour réaliser cette séquence binaire, en fonction du courant de polarisation. La courbe du haut permet de déterminer la durée maximale d'une séquence binaire pour une diminution du SOC limitée à 2%.

Selon un modèle simplifié, l'accumulateur 4 est assimilable à une source de tension continue 42 connectée en série avec une impédance interne 41 dont l'ordre de grandeur est de 1 mΩ. La branche du circuit 3 incluant le transistor de puissance 32 et la résistance de décharge 33 est avantageusement dimensionnée de sorte que le courant traversant cette branche ne soit pas négligeable rapport au courant de charge ou de décharge de la batterie 2. On pourra par exemple dimensionner la résistance 33 de sorte que la fermeture du transistor de puissance 32 induit une baisse de tension de l'accumulateur 4 l'ordre de 0,1 %, voire de l'ordre de 1% durant la communication du circuit 3 vers le calculateur 52. Une baisse de tension subite de l'ordre de 0,1 % aux bornes de l'accumulateur 4 est aisément détectable, la tension aux bornes des accumulateurs 4 subissant normalement des variations relativement lentes. La résistance 33 pourra par exemple présenter une valeur de l'ordre de 3Ω. Ainsi, si l'accumulateur est traversé par un courant de 100 A, la résistance 33 est traversée par un courant de 1 A durant la fermeture du transistor 32. Afin de limiter la consommation de courant dans le circuit 3, la résistance de décharge 33 présente une valeur au moins 50 fois supérieure à l'impédance interne de l'accumulateur 4 à la fréquence d'une séquence binaire.

Bien que le circuit 3 ait été décrit sur la base d'un schéma incluant une résistance 33 et un transistor de puissance 32 en série, le circuit 3 peut être réalisé par tous moyens appropriés, par exemple en utilisant un transistor de puissance présentant une résistance de conduction permettant de générer une baisse de tension de l'accumulateur 4 avec l'ordre de grandeur souhaité.

Le calculateur 52 peut réaliser l'identification d'un circuit 3 par l'intermédiaire d'une corrélation avec des séquences préenregistrées. L'identification d'un circuit 3 peut également être réalisée par l'intermédiaire d'un démodulateur du calculateur 52.

La figure 8 illustre une batterie 2 d'une première variante d'un deuxième mode de réalisation de l'invention. Des cellules électrochimiques 11 sont ici connectées en parallèle dans plusieurs étages ou modules électriques 12. Les étages 12 sont connectés en série.

Chaque cellule 11 est associée à un interrupteur 13 (désigné par interrupteur de cellule 13 par la suite) qui lui est propre, disposé en série, qui permet de déconnecter cette cellule du reste de la batterie par son ouverture. De plus chaque étage 12 comprend aussi un interrupteur 14 (désigné par interrupteur d'étage 14 par la suite) en parallèle des cellules 11 de l'étage 12, permettant ainsi de court-circuiter l'ensemble de l'étage.

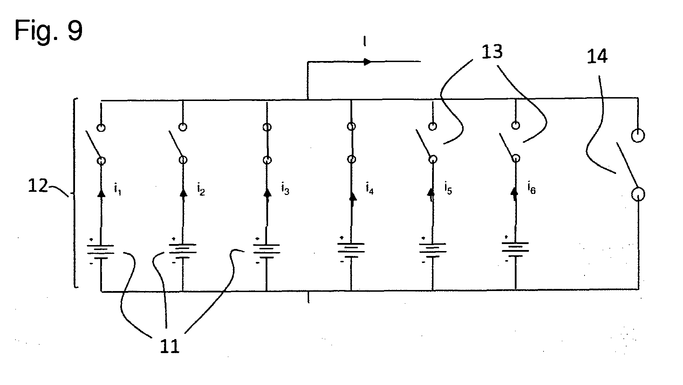

La figure 9 illustre plus en détail un étage 12 de la batterie 2. L'étage 12 comprend une borne inférieure reliée à un étage voisin inférieur et une borne supérieure pour une liaison série avec l'étage voisin supérieur. Selon cet exemple, cet étage 12 comprend six cellules 11 disposées en parallèle. Plus précisément, l'étage comprend d'abord six branches parallèles disposées entre ses bornes supérieure et inférieure, sur lesquelles sont disposées une cellule 11 et un interrupteur de cellule 13, apte à déconnecter ou non la cellule d'une des deux bornes. L'étage 12 comprend une septième branche sur laquelle est disposé un interrupteur d'étage 14, en parallèle avec les cellules 11, apte à shunter les cellules 11. Sur l'exemple illustré, seules les troisième et quatrième cellules sont utilisées car leurs interrupteurs de cellule 13 respectifs sont fermés, alors que tous les autres interrupteurs de cellule sont ouverts. D'autre part, l'interrupteur d'étage 14 est ouvert pour mettre l'étage 12 dans sa configuration normale de stockage ou de restitution d'énergie.

Les différents interrupteurs 13, 14 sont réalisés à l'aide de transistors de puissance de préférence, par exemple des transistors de type NMOS, qui apportent un gain en conductivité dans leur état passant par rapport à des transistors PMOS qui pourraient en variante être utilisés. En variante, il est aussi possible d'utiliser d'autres types de transistors tel que des bipolaires, FET, JFET, IGBT, etc.

Le fonctionnement de ce dispositif va maintenant être expliqué. Lors de son utilisation en configuration habituelle de fonctionnement, au moins un des transistors de cellule 13 est fermé, alors que le transistor d'étage 14 est ouvert, ce qui permet aux cellules 11 associées aux transistors de cellule 13 fermés de délivrer une tension et un courant qui traverse les transistors fermés et qui va finalement contribuer à l'alimentation de la charge connectée aux bornes de la batterie 2.

Lorsque tous les interrupteurs 13 sont fermés et que l'interrupteur 14 est ouvert, chaque accumulateur 11 voit circuler un courant dont la valeur dépend du courant de polarisation I de la batterie 2 et du nombre d'accumulateurs 11 dans l'étage 12.

En appliquant une séquence binaire à une fréquence donnée au transistor 13 de la première branche par exemple, on fait varier le courant que voit son accumulateur 11 en série entre 0 et i1. Les autres branches de l'étage 12 voient aussi un courant et une tension variables du fait du pilotage imposé à la première branche. Le courant dans ces autres branches est compris entre ik et ik + i1/(k-1). En répétant cette séquence binaire pour les différents transistors 13 de l'étage, le calculateur 52 pourra déterminer l'impédance de cet étage à la fréquence donnée.

Les ouvertures/fermetures des interrupteurs 13 et 14 peuvent être commandées par une carte électronique de l'étage 12, selon des séquences binaires à des fréquences calibrées prédéfinies.

Cette carte électronique peut effectuer des mesures de tension aux bornes des différents accumulateurs 11 afin de transmettre une valeur d'impédance de l'étage 12 au calculateur 52. Cette valeur d'impédance peut ainsi être comparée à la valeur d'impédance déterminée par le calculateur 52.

Dans une deuxième variante du deuxième mode de réalisation, on reprend la structure de la première variante, et on supprime l'interrupteur d'étage 14 dans chacun des étages.

Le fonctionnement de ce dispositif peut être le suivant. Lors de son utilisation en configuration habituelle de fonctionnement, au moins un (et généralement tous) des transistors de cellule 13 est fermé, alors que le transistor d'étage 14 est ouvert, ce qui permet aux cellules 11 associées aux transistors de cellule 13 fermés de délivrer une tension et un courant qui traverse les transistors fermés et qui va finalement contribuer à l'alimentation de la charge connectée aux bornes de la batterie 2.

Lorsque tous les interrupteurs 13 sont fermés et que l'interrupteur 14 est ouvert, chaque accumulateur 11 voit circuler un courant dont la valeur dépend du courant de polarisation I de la batterie 2 et du nombre d'accumulateurs 11 dans l'étage 12.

En mode de détermination de l'impédance de l'étage 12, on alterne entre un premier état dans lequel tous les interrupteurs 13 de l'étage 12 sont fermés, et un deuxième état dans lequel seulement un des interrupteurs 13 de l'étage 12 est fermé. Cette alternance est réalisée selon une séquence binaire à une fréquence donnée. L'interrupteur 13 qui reste fermé dans ce mode correspond à la cellule 11 dont on souhaite mesurer l'impédance $Z_m$.

Dans le premier état, on vérifie la relation $U= Z_m * I_m$, avec $I_m$ l'intensité traversant la cellule 11 dont on souhaite mesurer l'impédance $Z_m$. Avec des impédances proches pour les différentes cellules, la relation peut s'approximer par $U= Z_m* I/n$, avec n le nombre de cellules connectées en parallèle dans l'étage 12 et I le courant de polarisation de la batterie 2. Dans le deuxième état, $U=Z_m*I$

Entre les deux états, la cellule 11 dont on souhaite mesurer l'impédance $Z_m$ est traversée alternativement par un courant I et par un courant I/n.

Pour garantir la fiabilité de la mesure, il est souhaitable que le fonctionnement du système reste linéaire et invariant (système dit LTI) durant le deuxième mode de fonctionnement. La variation $dI_{max}$ entre les deux états doit alors vérifier la relation suivante :

$$dImax > I - I/n, \text{ soit}$$

$I < dImax * n / (n-1)$ avec une valeur de $dImax$ de quelques centaines de mA (en fonction de l'état de charge de la batterie, du temps de mesure et du courant de polarisation). Par conséquent, le mode de détermination d'impédance doit avantageusement être utilisé lorsque la batterie 2 fournit un courant de polarisation assez réduit.

En répétant le mode de détermination de l'impédance pour les différents transistors 13 de l'étage, le calculateur 52 pourra déterminer l'impédance de cet étage 12 à la fréquence donnée.

Le courant peut être mesuré dans chaque branche ou peut être déterminé par une connaissance préalable assez précise des impédances des différentes branches (par une calibration initiale et un suivi postérieur).

Les ouvertures/fermetures des interrupteurs 13 peuvent être commandées par une carte électronique de l'étage 12, selon des séquences binaires à des fréquences calibrées prédéfinies.

Cette carte électronique peut transmettre une valeur d'impédance de l'étage 12 au calculateur 52. Cette valeur d'impédance peut ainsi être comparée à la valeur d'impédance déterminée par le calculateur 52.

**Revendications**

1. Système (1) de batterie d'accumulateurs, comprenant :

   - plusieurs étages connectés en série, chaque étage incluant au moins un accumulateur électrochimique (4) et au moins un interrupteur ;
   - une connexion électrique de puissance (71,72) destinée à raccorder une charge électrique (55) auxdits étages ;
   - un dispositif de contrôle (52) raccordé aux étages par l'intermédiaire de la connexion électrique de puissance ;

   **caractérisé en ce que** :

   - le système comprend en outre plusieurs circuits (3), chaque circuit étant associé à un étage et étant configuré pour générer une variation d'amplitude de tension aux bornes de l'étage associé par application sur un interrupteur de l'étage d'une séquence binaire à une première fréquence, chaque séquence binaire étant différente des autres séquences binaires pour permettre de discriminer un étage par rapport aux autres étages ;
   - le dispositif de contrôle (52) est programmé pour :

     - mesurer une variation de la tension aux bornes de l'étage en réponse à l'application de la séquence binaire sur cet étage;
     - identifier l'étage à l'origine de la variation de tension par recherche de la séquence binaire associée à cet étage ;
     - déterminer l'impédance de l'étage identifié pour la première fréquence à partir de la variation de tension mesurée.

2. Système de batterie selon la revendication 1, dans lequel lesdits circuits sont configurés pour appliquer leur séquence binaire sous forme de chirp, de créneau ou de séquence binaire pseudo-aléatoire.

3. Système de batterie selon la revendication 1 ou 2, dans lequel ledit dispositif de contrôle (52) est configuré pour effectuer ladite détection lorsque lesdits étages alimentent une charge électrique connectée à la connexion électrique de puissance.

4. Système de batterie selon l'une quelconque des revendications précédentes, dans lequel :

   - lesdits circuits (3) sont configurés pour :

     - mesurer la tension aux bornes de leur étage durant l'application de ladite séquence binaire ;
     - déterminer l'impédance de l'étage à partir de la tension mesurée par le circuit;
     - émettre la valeur d'impédance déterminée par ce circuit vers le dispositif de contrôle par courant porteur ;
     - ledit dispositif de contrôle (52) étant configuré pour comparer la valeur d'impédance qu'il a déterminée avec la valeur d'impédance émise par le circuit.

5. Système de batterie selon la revendication 4, dans lequel ledit circuit est configuré pour émettre par courant porteur en générant une variation de tension aux bornes de l'étage associé par application sur ledit interrupteur de l'étage d'une séquence binaire à une deuxième fréquence différente de la première, ladite séquence binaire à cette deuxième fréquence présentant un entête de discrimination de l'étage identique à un entête de discrimination de l'étage de la séquence binaire à la première fréquence.

6. Système de batterie selon l'une quelconque des revendications précédentes, dans lequel ledit dispositif de contrôle (52) est configuré pour extrapoler un paramètre de fonctionnement dudit étage en fonction de l'impédance déterminée et en fonction de ladite première fréquence.

7. Système selon l'une quelconque des revendications précédentes, dans lequel ladite première fréquence est comprise entre 0.1 mHz et 10 Hz et dans lequel le dispositif de contrôle (52) extrapole l'état de charge dudit étage en fonction de ladite valeur d'impédance déterminée.

8. Système de batterie selon l'une quelconque des revendications 1 à 6, dans lequel ladite première fréquence est comprise entre 10Hz et 5 KHz et dans lequel le dispositif de contrôle (52) extrapole l'état de vieillissement dudit étage émetteur en fonction de ladite valeur d'impédance déterminée.

**9.** Système de batterie selon l'une quelconque des revendications 1 à 6, dans lequel ladite première fréquence est supérieure à 5KHz et dans lequel le dispositif de contrôle (52) extrapole l'état de la connectique dudit étage en fonction de ladite valeur d'impédance déterminée.

**10.** Système de batterie selon l'une quelconque des revendications 1 à 6, dans lequel :

- chacun desdits circuits est configuré pour générer une variation d'amplitude de tension aux bornes de l'étage associé par application sur un interrupteur de l'étage d'une séquence binaire à une troisième fréquence, chaque séquence binaire étant différente des autres séquences binaire pour permettre de discriminer un étage par rapport aux autres étages ;
- le dispositif de contrôle (52) étant programmé pour :
- mesurer une variation de la tension aux bornes de l'étage en réponse à l'application de la séquence binaire à la troisième fréquence sur cet étage;
- identifier l'étage à l'origine de cette variation de tension par recherche de la séquence binaire associée à cet étage ;
- déterminer l'impédance de l'étage identifié pour la troisième fréquence, à partir de la variation de tension mesurée ;
- extrapoler un modèle de la fonction de transfert dudit étage en fonction des valeurs d'impédance déterminées pour les première et troisième fréquences.

**11.** Système selon l'une quelconque des revendications précédentes, dans lequel la tension aux bornes de la connexion électrique de puissance est supérieure à 50V.

**12.** Système selon l'une quelconque des revendications précédentes, dans lequel lesdits circuits (3) sont alimentés électriquement par leur étage respectif (4).

**13.** Système selon l'une quelconque des revendications précédentes, dans lequel lesdits circuits (3) induisent lesdites variations d'amplitude de tension par connexion d'une charge électrique (33) entre les bornes de cet étage.

**14.** Système selon l'une quelconque des revendications 1 à 12, dans lequel chaque étage (12) inclut plusieurs branches connectées en parallèle, chaque branche comprenant un accumulateur électrochimique (11) connecté en série avec un interrupteur (13), un desdits circuits étant configuré pour appliquer ladite séquence binaire à la première fréquence sur au moins un desdits interrupteurs.

**Patentansprüche**

**1.** Batteriesystem (1) aus Akkumulatoren, umfassend:

- mehrere in Reihe geschaltete Module, wobei jedes Modul mindestens einen elektrochemischen Akkumulator (4) und mindestens einen Schalter umfasst,
- eine elektrische Leistungsverbindung (71, 72) zur Verbindung einer elektrischen Last (55) mit den Modulen,
- eine Steuervorrichtung (52), die über die elektrische Leistungsverbindung mit den Modulen verbunden ist,

**dadurch gekennzeichnet, dass**

- das System ferner mehrere Schaltkreise (3) umfasst, wobei jeder Schaltkreis einem Modul zugeordnet ist und dazu ausgebildet ist, an den Anschlüssen des zugeordneten Moduls eine Spannungsamplitudenänderung zu erzeugen, indem an einen Schalter des Moduls eine binäre Sequenz mit einer ersten Frequenz angelegt wird, wobei sich jede binäre Sequenz von den anderen binären Sequenzen unterscheidet, um ein Modul von den anderen Modulen unterscheiden zu können;
- die Steuervorrichtung (52) dazu programmiert ist:

- eine Spannungsänderung als Reaktion auf das Anlegen der binären Sequenz an das Modul an den Anschlüssen dieses Moduls zu messen;
- das Modul, das die Spannungsänderung verursacht hat, durch Suche nach der binären Sequenz, die diesem Modul zugeordnet ist, zu identifizieren,
- die Impedanz des identifizierten Moduls bei der ersten Frequenz anhand der gemessenen Spannungsänderung zu bestimmen.

2. Batteriesystem nach Anspruch 1, wobei die Schaltkreise dazu ausgebildet sind, ihre binäre Sequenz in der Form eines Chirps, eines Rechteckimpulses oder einer Pseudorandom Binary Sequence anzulegen.

3. Batteriesystem nach der Anspruch 1 oder 2, wobei die Steuervorrichtung (52) dazu ausgebildet ist, die Detektion durchzuführen, wenn die Module eine mit der elektrischen Leistungsverbindung verbundene elektrische Ladung versorgen.

4. Batteriesystem nach einem der vorangehenden Ansprüche, wobei:

   - die Schaltkreise (3) dazu ausgebildet sind:

     - die Spannung an den Anschlüssen ihres Modul zu messen, während die binäre Sequenz anliegt,
     - die Impedanz des Moduls anhand der von dem Schaltkreis gemessenen Spannung zu bestimmen,
     - den Wert der von dem Schaltkreis bestimmen Impedanz an die Steuervorrichtung über einen Trägerstrom auszugeben,
     - die Steuervorrichtung (52) dazu ausgebildet ist, den von ihr bestimmen Impedanzwert mit dem von dem Schaltkreis ausgegebenen Impedanzwert zu vergleichen.

5. Batteriesystem nach Anspruch 4, wobei der Schaltkreis dazu ausgebildet ist, indem eine Spannungsänderung an den Anschlüssen des zugeordneten Moduls erzeugt wird, indem an den Schalter des Moduls eine binäre Sequenz mit einer zweiten von der ersten Frequenz verschiedenen Frequenz angelegt wird, über einen Trägerstrom die binäre Sequenz mit der zweiten Frequenz auszugeben, die einen Header zur Modulunterscheidung darstellt, der mit einem Header zur Modulunterscheidung der binären Sequenz mit der ersten Frequenz identisch ist.

6. Batteriesystem nach einem der vorangehenden Ansprüche, wobei die Steuervorrichtung (52) dazu ausgebildet ist, einen Funktionsparameter des Moduls in Abhängigkeit von der bestimmen Impedanz und in Abhängigkeit von der ersten Frequenz zu extrapolieren.

7. System nach einem der vorangehenden Ansprüche, wobei die erste Frequenz zwischen 0,1 mHz und 10 Hz liegt und wobei die Steuervorrichtung (52) den Zustand des Moduls in Anhängigkeit von dem bestimmen Impedanzwert extrapoliert.

8. Batteriesystem nach einem der Ansprüche 1 bis 6, wobei die erste Frequenz zwischen 10 Hz und 5 kHz liegt und wobei die Steuervorrichtung (52) die Alterung des ausgebenden Moduls in Abhängigkeit von dem bestimmen Impedanzwert extrapoliert.

9. Batteriesystem nach einem der Ansprüche 1 bis 6, wobei die erste Frequenz über 5 kHz liegt und wobei die Steuervorrichtung (52) den Zustand der Anschlusstechnik des Moduls in Abhängigkeit von dem bestimmen Impedanzwert extrapoliert.

10. Batteriesystem nach einem der Ansprüche 1 bis 6, wobei:

    - jeder der Schaltkreise dazu ausgebildet ist, an den Anschlüssen des zugeordneten Moduls eine Spannungsamplitudenänderung zu erzeugen, indem an einen Schalter des Moduls eine binäre Sequenz mit einer dritten Frequenz angelegt wird, wobei sich jede binäre Sequenz von den anderen binären Sequenzen unterscheidet, um ein Modul von den anderen Modulen unterscheiden zu können, wobei:
    - wobei die Steuervorrichtung (52) dazu programmiert ist:

      - eine Spannungsänderung als Reaktion auf das Anlegen der binären Sequenz mit der dritten Frequenz an das Modul an den Anschlüssen dieses Moduls zu messen,
      - das Modul, das die Spannungsänderung verursacht hat, durch Suche nach der binären Sequenz, die diesem Modul zugeordnet ist, zu identifizieren,
      - die Impedanz des identifizierten Moduls bei der dritten Frequenz anhand der gemessenen Spannungsänderung zu bestimmen,
      - ein Modell der Übertragungsfunktion des Moduls in Abhängigkeit von dem für die erste und dritte Frequenz bestimmen Impedanzwert zu extrapolieren.

**11.** System nach einem der vorangehenden Ansprüche, wobei die Spannung an den Anschlüssen der elektrischen Leistungsverbindung über 50V liegt.

**12.** System nach einem der vorangehenden Ansprüche, wobei die Schaltkreise (3) durch ihr jeweiliges Modul (4) mit Strom versorgt werden.

**13.** System nach einem der vorangehenden Ansprüche, wobei die Schaltkreise (3) die Spannungsamplitudenänderungen durch das Einschalten einer elektrischen Last (33) zwischen den Anschlüssen dieses Moduls hervorrufen.

**14.** System nach einem der Ansprüche 1 bis 12, wobei jedes Modul (12) mehrere parallel geschaltete Zweige umfasst, wobei jeder Zweig einen elektrochemischen Akkumulator (11) umfasst, der mit einem Schalter (13) in Reihe geschaltet ist, wobei einer der Schaltkreise dazu ausgebildet ist, die binäre Sequenz mit der ersten Frequenz an wenigstens einen der Schalter anzulegen.

**Claims**

**1.** System (1) of accumulator batteries, comprising:

- a plurality of stages connected in series, each stage including at least one electrochemical accumulator (4) and at least one switch;
- a power electrical connection (71, 72) intended to couple an electrical load (55) to said stages;
- a control device (52) coupled to the stages via the power electrical connection;

**characterized in that**:

- the system further comprises a plurality of circuits (3), each circuit being associated with a stage and being configured to generate a voltage amplitude variation at the terminals of the associated stage by application to a switch of the stage of a binary sequence at a first frequency, each binary sequence being different from the other binary sequences to make it possible to discriminate one stage relative to the other stages;
- the control device (52) is programmed to:

- measure a variation of the voltage at the terminals of the stage in response to the application of the binary sequence to this stage;
- identify the stage originating the voltage variation by searching for the binary sequence associated with this stage;
- determine the impedance of the stage identified for the first frequency from the measured voltage variation.

**2.** Battery system according to Claim 1, in which said circuits are configured to apply their binary sequence in chirp, pulse or pseudo-random binary sequence form.

**3.** Battery system according to Claim 1 or 2, in which said control device (52) is configured to perform said detection when said stages power an electrical load connected to the power electrical connection.

**4.** Battery system according to any one of the preceding claims, in which:

- said circuits (3) are configured to:

- measure the voltage at the terminals of their stage during the application of said binary sequence;
- determine the impedance of the stage from the voltage measured by the circuit;
- transmit the impedance value determined by this circuit to the control device by carrier current;

- said control device (52) being configured to compare the impedance value that it has determined with the impedance value transmitted by the circuit.

**5.** Battery system according to Claim 4, in which said circuit is configured to transmit by carrier current by generating a voltage variation at the terminals of the associated stage by application to said switch of the stage of a binary sequence at a second frequency different from the first, said binary sequence at this second frequency having a discrimination header of the stage identical to a discrimination header of the stage of the binary sequence at the first frequency.

6.  Battery system according to any one of the preceding claims, in which said control device (52) is configured to extrapolate an operating parameter of said stage as a function of the determined impedance and as a function of said first frequency.

7.  System according to any one of the preceding claims, in which said first frequency is between 0.1 mHz and 10 Hz and in which the control device (52) extrapolates the stage of charge of said stage as a function of said determined impedance value.

8.  Battery system according to any one of Claims 1 to 6, in which said first frequency is between 10 Hz and 5 KHz and in which the control device (52) extrapolates the stage of aging of said transmitting stage as a function of said determined impedance value.

9.  Battery system according to any one of Claims 1 to 6, in which said first frequency is greater than 5 KHz and in which the control device (52) extrapolates the state of the connections of said stage as a function of said determined impedance value.

10. Battery system according to any one of Claims 1 to 6, in which:

    - each of said circuits is configured to generate a voltage amplitude variation at the terminals of the associated stage by application to a switch of the stage of a binary sequence at a third frequency, each binary sequence being different from the other binary sequences to make it possible to discriminate one stage relative to the other stages;
    - the control device (52) being programmed to:

        - measure a variation of the voltage at the terminals of the stage in response to the application of the binary sequence at the third frequency to this stage;
        - identify the stage originating this voltage variation by searching for the binary sequence associated with this stage;
        - determine the impedance of the stage identified for the third frequency, from the measured voltage variation;
        - extrapolate a model of the transfer function of said stage as a function of the impedance values determined for the first and third frequencies.

11. System according to any one of the preceding claims, in which the voltage at the terminals of the power electrical connection is greater than 50 V.

12. System according to any one of the preceding claims, in which said circuits (3) are powered electrically by their respective stage (4).

13. System according to any one of the preceding claims, in which said circuits (3) induce said voltage amplitude variations by the connection of an electrical load (33) between the terminals of this stage.

14. System according to any one of Claims 1 to 12, in which each stage (12) includes a plurality of branches connected in parallel, each branch comprising an electrochemical accumulator (11) connected in series with a switch (13), one of said circuits being configured to apply said binary sequence at the first frequency to at least one of said switches.

Fig. 1

Fig. 2

Fig. 3

## Fig. 4

## Fig. 5

## Fig. 6

Fig. 7

Fig. 8

## Fig. 9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- WO 2008046980 A

### Littérature non-brevet citée dans la description

- **M. DONG.** Dynamic modeling of Li-ion batteries using an équivalent electrical circuit. *Journal of the Electrochemical Society,* vol. 158 (3), A326